# EUROPEAN PATENT APPLICATION

(11) **EP 4 593 071 A1**
(43) Date of publication of application: **30.07.2025**
(21) Application number: 23871258.2
(22) Date of filing: 03.03.2023
(51) Int. Cl.: H01L 21/677, H01L 21/67, H01L 21/683

(54) **ELECTROSTATIC CARRIER, TREATMENT SYSTEM, AND TREATMENT METHOD**

(30) Priority: 27.09.2022 JP 2022153556
(71) Applicant: Tokyo Electron Limited, Tokyo 107-6325 (JP)
(72) Inventor: FUKUOKA, Tetsuo, Koshi City, Kumamoto 861-1116 (JP)
(74) Representative: Manitz Finsterwald Patent- und Rechtsanwaltspartnerschaft mbB
(86) International application number: PCT/JP2023/008110
(87) International publication number: WO 2024/070009

(57) **Abstract**

A processing method of processing multiple chips using an electrostatic carrier, which includes a main body having conductivity and provided with multiple through holes in a thickness direction thereof; and an insulating layer formed on a front surface of the main body, includes arranging and placing the multiple chips on a holding surface of the electrostatic carrier; supplying power to the main body to electrically charge the main body; and bringing an earth wire into contact with the chip to generate an electrostatic force between the chip and the main body.

## Description

### TECHNICAL FIELD

The various aspects and embodiments described herein pertain generally to an electrostatic carrier, a processing system, and a processing method.

### BACKGROUND

Patent Document 1 discloses a chip-on-wafer (CoW) bonding method for mounting a chip on a wafer. In this chip-on-wafer bonding method, before a plurality of chips are finally bonded on corresponding bonding portions of a substrate, a surface activation treatment and a hydrophilization treatment are performed on bonding surfaces of the chips, and the plurality of chips are preliminarily bonded on the substrate.

Patent Document 2 discloses a reinforcing member for a thin plate material such as a silicon wafer. This reinforcing member has a reinforcing member main body provided with a thin plate-shaped electrostatic holder in which an electrode is embedded inside an electrical insulating layer (polyimide layer). Then, by applying a high voltage to the electrode and supplying the reinforcing member with electric charges whose polarity is opposite to that of the voltage applied to the electrode, an attracting force is exerted in the electrostatic holder to attract a target object to be reinforced, enabling the reinforming member main body to function as the reinforcing member.

### PRIOR ART DOCUMENT

Patent Document 1: Japanese Patent No. 6,337,400
Patent Document 2: Japanese Patent Laid-open Publication No. 2009-099674

### DISCLOSURE OF THE INVENTION

### PROBLEMS TO BE SOLVED BY THE INVENTION

Exemplary embodiments provide an electrostatic carrier capable of appropriately carrying out a transfer of diced chips to a wafer in a chip-on-wafer manufacturing process.

### MEANS FOR SOLVING THE PROBLEMS

In an exemplary embodiment, an electrostatic carrier used in a chip-on-wafer manufacturing process includes a main body having conductivity and provided with multiple through holes in a thickness direction thereof; and an insulating layer formed on a front surface of the main body.

### EFFECT OF THE INVENTION

According to the exemplary embodiments, it is possible to provide an electrostatic carrier capable of appropriately carrying out a transfer of diced chips to a wafer in a chip-on-wafer manufacturing process.

### BRIEF DESCRIPTION OF THE DRAWINGS

**FIG. 1** is an explanatory diagram schematically illustrating a structure of a chip attached to a dicing sheet.
**FIG. 2** is a cross sectional view schematically illustrating a structure of an electrostatic carrier according to an exemplary embodiment.
**FIG. 3** is a plan view schematically illustrating the structure of the electrostatic carrier according to the exemplary embodiment.
**FIG. 4** is a cross sectional view schematically illustrating another structure of the electrostatic carrier.
**FIG. 5** is a plan view schematically illustrating the another structure of the electrostatic carrier.
**FIG. 6** is a cross sectional view schematically illustrating a structure of a wafer to which the chip is to be bonded.
**FIG. 7** is a plan view schematically illustrating a configuration of a processing system according to the exemplary embodiment.
**FIG. 8** is a cross sectional view schematically illustrating a configuration of a chip placing apparatus.
**FIG. 9** is an explanatory diagram illustrating another example structure of a charge eliminator.
**FIG. 10** is an explanatory diagram illustrating still another example structure of the charge eliminator.
**FIG. 11** is a cross sectional view schematically illustrating a configuration of a bonding apparatus.
**FIG. 12** is a flowchart showing main processes of a chip-on-wafer manufacturing process according to the exemplary embodiment.
**FIG. 13A** to **FIG. 13F** are explanatory side views showing the main processes of the chip-on-wafer manufacturing process according to the exemplary embodiment.
**FIG. 14A to FIG. 14C** are explanatory side views showing an operation in which the chips are electrostatically attracted to the electrostatic carrier in the chip placing apparatus.
**FIG. 15** is an explanatory diagram illustrating an operation in which the chip is separated from the electrostatic carrier in the bonding apparatus.
**FIG. 16** is an explanatory diagram illustrating an operation in which the chip is separated from the electrostatic carrier in the bonding apparatus.
**FIG. 17** is a cross sectional view illustrating another configuration example of the bonding apparatus.
**FIG. 18** is a cross sectional view illustrating yet another configuration example of the bonding apparatus.
**FIG. 19** is a cross sectional view illustrating still yet another configuration example of the bonding apparatus.

### DETAILED DESCRIPTION

Recently, in a manufacturing process for semiconductor devices, a chip-on-wafer (CoW) manufacturing process has been examined as one way of a 3D packaging technology to meet a demand for higher performance and higher density of devices. Manufacture of a chip-on-wafer is carried out by a method described in Patent Document 1, for example.

In this chip-on-wafer manufacturing process, prior to final mounting of a semiconductor chip (hereinafter, simply referred to as "chip") onto a semiconductor substrate (hereinafter, simply referred to as "wafer"), a series of treatments including surface activation, hydrophilization, and removal of a protective film need to be performed on a bonding surface of the chip, as stated in Patent Document 1. These series of treatments on the chip are carried out in a state where the chip is placed on a dicing tape fixed to a dicing frame. When the series of treatments are performed in such a state, however, the dicing tape on which the chip is placed may be damaged, so it may not be possible to reuse the dicing tape.

To solve this problem, the inventors of the present application have conducted intensive research and found out that it is possible to suppress the damage to the dicing tape in the chip-on-wafer manufacturing process by applying an electrostatic holding mechanism. Specifically, in the chip-on-wafer manufacturing process, instead of performing the series of treatments on the chip on the dicing tape, the treatments are performed in a state where the chip is held by a carrier substrate having an attracting/holding function by an electrostatic (Coulomb) force (hereinafter referred to as "electrostatic carrier (ESW: Electro Static Carrier Wafer)").

Although Patent Document 2 discloses the electrostatic reinforcing device for holding and reinforcing a thin plate material such as a silicon wafer, it does not mention anything about the aforementioned inventive concept of holding the plurality of chips on the carrier wafer by electrostatic attraction and finally mounting the chips on a mounting target wafer.

In addition, as disclosed in Patent Document 2, in the electrostatic carrier used for a transfer of the thin-plate material such as the silicon wafer, an insulating layer (e.g., a polyimide layer) covering a periphery of an electrode to insulate it is an essential component. If, however, the insulating layer covering the electrode is solid (if its elastic modulus is high), electric charges may leak through conductive liquids used in the aforementioned series of treatments, which may raise a risk that the electrostatic attracting force of the thin-plate material with respect to the electrostatic carrier may be lost.

Patent Document 2 does not mention anything about this deterioration of the electrostatic attracting force as a result of the electric charges' leaking through the conductive liquids in this way.

In view of the foregoing, exemplary embodiments of the present disclosure provide an electrostatic carrier capable of appropriately carrying out a transfer of diced chips to a wafer in the chip-on-wafer manufacturing process. Hereinafter, a processing system and a processing method according to an exemplary embodiment will be described with reference to the accompanying drawings. In the present specification and drawings, parts having substantially the same functions and configurations will be assigned same reference numerals, and redundant description thereof will be omitted.

In a processing system 10 according to the present exemplary embodiment, which will be described later, a plurality of chips C that are arranged and attached on an adhesive surface of a dicing tape T to be described later are disposed on an electrostatic carrier Cw to be described later, and the plurality of chips C on the electrostatic carrier Cw are bonded to a wafer W as a target on which the chips C are to be finally mounted (a chip-on-wafer manufacturing process). Hereinafter, in each of the plurality of chips C, a surface on which a device layer D to be described later is formed is referred to as a front surface Ca (or "device surface"), and a surface opposite to the front surface Ca (device surface) and attached to the dicing tape T is referred to as a rear surface Cb.

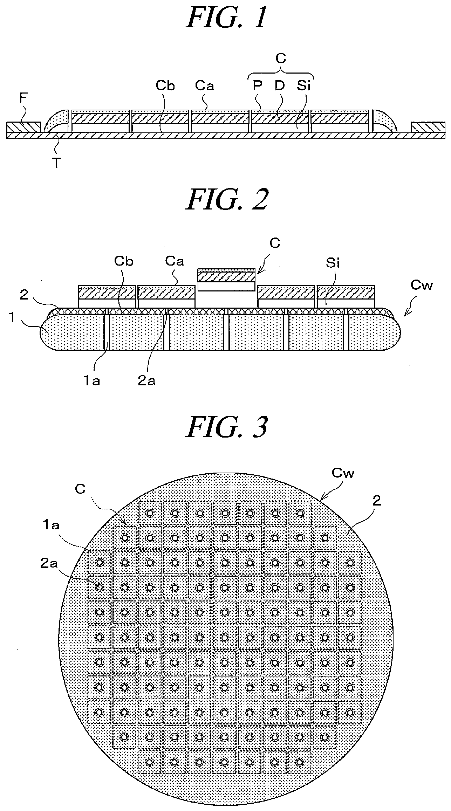

As shown in **FIG. 1****,** a silicon layer Si, a device layer D including a plurality of devices, and a protective film P for protecting the device layer D are sequentially formed on the chip C from the rear surface Cb side toward the front surface side Ca thereof. The silicon layer Si on the rear surface side Cb of the chip C is attracted to the dicing tape T.

In addition, the dicing tape T is fixed to a dicing frame F as shown in **FIG. 1** during a transfer in the processing system 10 to be described later.

The electrostatic carrier Cw has, on a top surface thereof, an attraction surface on which the plurality of chips C is held by electrostatically attracting and vacuum-attracting them. As illustrated in **FIG. 2****,** the electrostatic carrier Cw has a structure in which an insulating layer 2 is formed on a front surface of a main body 1. In the electrostatic carrier Cw according to the exemplary embodiment of the present disclosure, no electrode (electrode wiring pattern) for electrostatically attracting the chips C is formed in the main body 1. The electrostatic carrier Cw attracts and holds the silicon layer Si on the rear surface Cb side of the chip C, as shown in **FIG. 2****.**

The main body 1 has approximately the same diameter and thickness as the wafer W on which the chips C are to be mounted, which will be described later, and is made of a conductive material, such as silicon, aluminum, an aluminum alloy, stainless steel, titanium, or the like. In other words, a silicon substrate as a conductive substrate may be used as the main body 1. Alternatively, the main body 1 may have approximately the same diameter as the wafer W on which the chips C are to be mounted, which will be described later, and may have a thickness (for example, 500 µm to 1000 µm) different from that of the wafer W.

Further, as shown in **FIG. 2** and **FIG. 3****,** the main body 1 is provided with a plurality of through holes 1a formed in a thickness direction thereof so as to correspond to holding positions of the chips C within the attraction surface of the electrostatic carrier Cw. As an example, the holding positions of the chips C within the attraction surface of the electrostatic carrier Cw are arranged so as to correspond to bonding positions of the chips C on a mounting surface of the wafer W (mounting positions of the chips C).

The plurality of through holes 1a may be formed at any positions in the attraction surface of the electrostatic carrier Cw.

By way of example, the plurality of through holes 1a may be formed in one-to-one correspondence with the plurality of chips C held on the electrostatic carrier Cw, as illustrated in **FIG. 2** and **FIG. 3****.** In other words, the number of the plurality of through holes 1a may be the same as the number of the chips C held on the electrostatic carrier Cw.

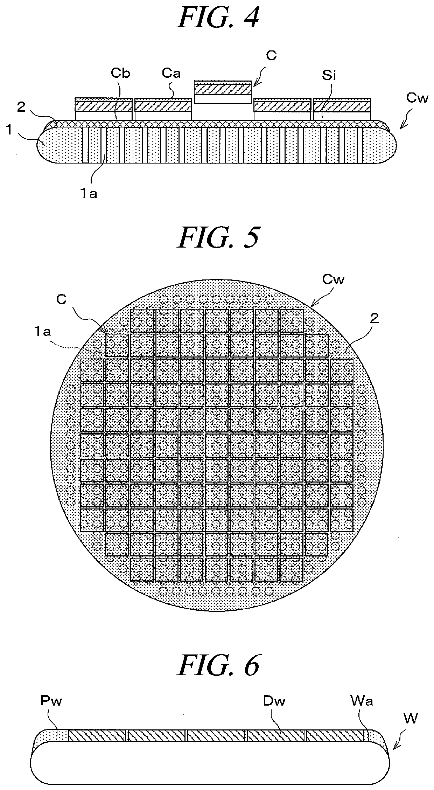

Alternatively, as another example of the plurality of through holes 1a, a multiple number of through holes 1a may be formed to correspond to each of the plurality of chips C held on the electrostatic carrier Cw, as shown in **FIG. 4** and **FIG. 5****.** In other words, the number of the plurality of through holes 1a may be greater than the number of the plurality of chips C held on the electrostatic carrier Cw. In this case, although the number, size, interval, and layout of the through holes 1a are not particularly limited, it is desirable to choose the number, size, and interval allowing strength (rigidity) that does not cause deformation such as bending in the electrostatic carrier Cw. By way of example, the size of the through holes 1a is ϕ0.5 mm to 1.0 mm, and the interval between the through holes 1a (lattice width of metal portions remaining between the through holes 1a) is 0.5 mm to 1.0 mm.

The insulating layer 2 is a layer formed on the front surface of the main body 1, and is made of a material having flexibility and an insulation property, such as polyimide or ethylene-vinyl acetate copolymer (EVA). As shown in **FIG. 2****,** the insulating layer 2 constitutes the attraction surface for the chips C in the electrostatic carrier Cw. The insulating layer 2 has a thickness allowing the chips to be held on the electrostatic carrier Cw by electrostatic attraction, for example, 10 µm. In one example, as shown in **FIG. 2** and **FIG. 3****,** the insulating layer 2 is provided with a plurality of through holes 2a (second through holes) at positions corresponding to the holding positions of the chips C within the attraction surface of the electrostatic carrier Cw, that is, the positions of the plurality of through holes 1a formed in the main body 1. It is desirable that the plurality of through holes 2a have a smaller diameter than the plurality of through holes 1a formed in the main body 1.

Further, in the exemplary embodiment of the present disclosure, the statement that "the insulating layer 2 has flexibility" means that the elastic modulus of the insulating layer 2 on the main body 1 is 2 GPa or less, desirably 0.5 GPa or less.

In addition, in the exemplary embodiment of the present disclosure, the statement that "the insulating layer 2 has insulation property" means that an insulation breakdown voltage of the insulating layer 2 on the main body 1 is 30 kV or more, desirably 40 kV or more.

Furthermore, depending on the purpose of a processing on the chips C on the electrostatic carrier Cw, the insulating layer 2 may not have the plurality of through holes 2a (see **FIG. 4** and **FIG. 5****),** or the plurality of through holes 2a may be formed to have the same diameter as the plurality of through holes 1a formed in the main body 1.

In other words, in the electrostatic carrier Cw according to the exemplary embodiment of the present disclosure, it may be sufficient that the insulating layer 2 having the insulation property is formed on the front surface of the main body 1 which has conductivity and is provided with the plurality of through holes 1a.

The insulating layer 2 is formed on the main body 1 by any of various methods. By way of example, the insulating layer 2 may be a film formed by applying polyimide onto the front surface of the main body 1 by spin coating. As another example, the insulating layer 2 may be an insulating film formed by attaching an insulating film (for example, a polyimide film or a back grind (BG) tape) to the front surface of the main body 1.

The through holes 1a of the main body 1 and the through holes 2a of the insulating layer 2 are formed by any of various methods at any timing.

By way of example, in the case of forming both the through holes 1a of the main body 1 and the through holes 2a of the insulating layer 2, the through holes 1a and 2a may be formed simultaneously by laser radiation or the like after the insulating layer 2 is formed on a front surface of a silicon substrate corresponding to the main body 1. Alternatively, the formation of the through holes 1a in the main body 1 and the formation of the through holes 2a in the insulating layer 2 may be performed independently, and the insulating layer 2 may be then attached to the main body 1 while aligning the positions of the through holes 1a and 2a.

In addition, in the case of forming only the through holes 1a in the main body 1 without forming the through holes 2a in the insulating layer 2, an insulating film may be attached to the main body 1 after the through holes 1a are formed in the main body 1 by laser radiation, punching, or the like.

The electrostatic carrier Cw according to the exemplary embodiment of the present disclosure is configured as described above, and by generating an electrostatic (Coulomb) force between the electrostatic carrier Cw and the chip C, the chip C is attracted to and held on the attraction surface of the electrostatic carrier Cw. Details of how to hold the chip C by the electrostatic carrier Cw will be explained later.

The wafer W on which the chip C is to be mounted is a semiconductor wafer such as a silicon substrate or a glass substrate for use in a manufacturing process for a semiconductor device. As shown in **FIG. 6****,** a device layer Dw including a plurality of devices is formed on a front surface Wa as a mounting surface on which the chip C is to be mounted. As an example, the thickness of the wafer W is equal to or slightly larger than that of the aforementioned electrostatic carrier Cw. For example, the thickness of the wafer W is 800 µm.

The device layer Dw is divided into smaller sections each having approximately the same size as the chip C to be mounted, as shown in **FIG. 6****.** In other words, each of the smaller sections of the device layer Dw on the mounting surface of the wafer W becomes a bonding position (mounting position) of the chip C on the wafer W.

Further, a protective film Pw is formed on the front surface Wa of the wafer W, and the thickness of this protective film Pw is approximately equal to the thickness of the device layer Dw. In other words, on the front surface Wa side of the wafer W, there exist portions where the smaller sections of the device layer Dw are exposed and portions where the protective film Pw is exposed between these smaller sections of the device layer Dw.

Additionally, the size of the device layer Dw does not necessarily have to be approximately the same as that of the chips C to be mounted. That is, the device layer Dw may be larger or smaller than the chips C.

The wafer W is bonded to the chip C as will be described later. Before the wafer W is bonded to the chip C, various types of pre-treatments for the bonding are performed on the front surface Wa of the wafer W. More specifically, the front surface Wa of the wafer W is previously subjected to a series of pre-treatments including surface activation and hydrophilization in one or more pre-treatment apparatuses to be described later that are disposed in the processing system 10.

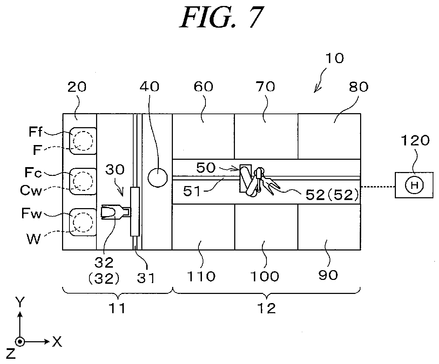

As depicted in **FIG. 7****,** the processing system 10 has a configuration in which a carry-in/out station 11 and a processing station 12 are connected as one body. In the carry-in/out station 11, FOUPs (Front Opening Unified Pods) Ff, Fc, and Fw capable of accommodating therein a multiple number of dicing frames F, a multiple number of electrostatic carriers Cw, and a multiple number of wafers W, respectively, are carried to/from, for example, the outside. The processing station 12 is equipped with various types of processing apparatuses configured to perform a series of chip-on-wafer manufacturing processes to be described later.

A FOUP placement table 20 is provided in the carry-in/out station 11. In the shown example, a plurality of, for example, three FOUPs Ff, Fc, and Fw are arranged on the FOUP placement table 20 in a row in the Y-axis direction. Further, the number and the layout of the FOUPs Ff, Fc, and Fw placed on the FOUP placement table 20 are not limited to the example of the present exemplary embodiment, but may be selected as required.

A transfer device 30 is provided adjacent to the FOUP placement table 20 on the positive X-axis side of the FOUP placement table 20. The transfer device 30 is configured to be movable on a transfer path 31 which is elongated in the Y-axis direction. Further, the transfer device 30 is equipped with, for example, two transfer arms 32 each of which is configured to hold and transfer the dicing frame F, the electrostatic carrier Cw, and the wafer W (hereinafter, these may be collectively referred to as "dicing frame F, *etc."*)*.* Each transfer arm 32 is configured to be movable in a horizontal direction and a vertical direction and pivotable around a horizontal axis and a vertical axis. Further, the configuration of the transfer arm 32 is not limited to the exemplary embodiment, and various other configurations may be adopted. The transfer device 30 is configured to be capable of transferring the dicing frame F, *etc.,* to/from the FOUPs Ff, Fc, and Fw of the FOUP placement table 20 and a transition device 40 to be described later.

In the carry-in/out station 11, the transition device 40 configured to deliver the dicing frame F, *etc.,* to/from the processing station 12 is provided adjacent to the transfer device 30 on the positive X-axis side of the transfer device 30.

The processing station 12 is equipped with a transfer device 50, the chip placing apparatus 60, a protective film removing apparatus 70, a surface modifying apparatus 80, a surface hydrophilizing apparatus 90, a pre-treatment apparatus 100, and a bonding apparatus 110. Here, the number and the layout of these various types of processing apparatuses are not limited to the present exemplary embodiment but may be selected as required.

The transfer device 50 is disposed on the positive X-axis side of the transition device 40. The transfer device 50 is configured to be movable on a transfer path 51 which is elongated in the X-axis direction. Further, the transfer device 50 has, for example, two transfer arms 52 each of which is configured to hold and transfer the dicing frame F, *etc..* Each transfer arm 52 is configured to be movable in a horizontal direction and a vertical direction and pivotable around a horizontal axis and a vertical axis, and is configured to be capable of transferring the dicing frame F, *etc.,* to/from the transition device 40 of the carry-in/out station 11 and the various types of processing apparatuses of the processing station 12.

In the chip placing apparatus 60, the plurality of chips C whose rear surface Cb sides are attached on the dicing tape T are arranged on the attraction surface of the electrostatic carrier Cw, which serves as a relay member when mounting the chips C onto the wafer W, such that the protective film P on the front surface Ca side faces upwards. That is, in the chip placing apparatus 60, the chips C are handed over from the dicing tape T onto the electrostatic carrier Cw without inverting front and rear surfaces of the chips C.

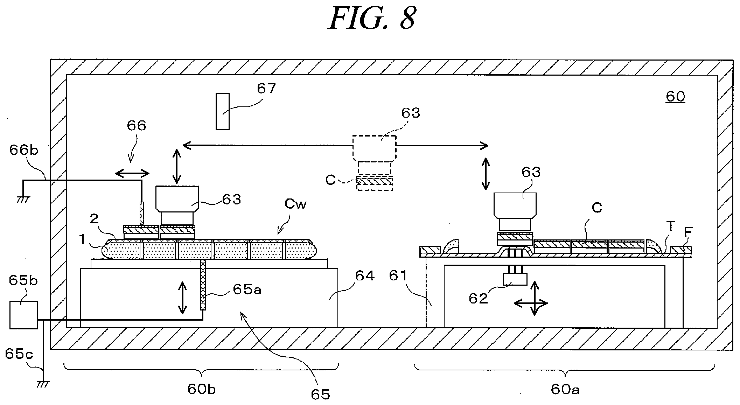

As illustrated in **FIG. 8****,** a pick-up area 60a and an arrangement area 60b are formed inside the chip placing apparatus 60. In the pick-up area 60a, the chips C are picked up from the dicing frame F. In the arrangement area 60b, the chips C are arranged on the electrostatic carrier Cw.

The pick-up area 60a is provided with a frame holder 61, a pusher 62, and a collet 63.

The frame holder 61 has a holding surface for the dicing frame F on a top surface thereof, and holds the dicing frame F transferred by the transfer device 50 such that the plurality of chips C attached to the dicing tape T faces upwards.

The pusher 62 is disposed below the frame holder 61, and configured to be movable horizontally relative to the frame holder 61. Here, as long as the frame holder 61 and the pusher 62 can be horizontally moved relative to each other, it may be sufficient that at least one of the frame holder 61 and the pusher 62 is configured to be movable. With this configuration, the pusher 62 selectively pushes one of the plurality of chips C on the dicing tape T upwards from below to raise it.

The collet 63 is disposed above the frame holder 61, and is configured to hold the one chip C pushed up by the pusher 62 from above and transfer the held chip C between the pickup area 60a and the arrangement area 60b.

The arrangement area 60b is provided with a carrier holder 64, a power supply 65, a charge eliminator 66, and an alignment mechanism 67.

The carrier holder 64 has a holding surface for the electrostatic carrier Cw on a top surface thereof, and holds the electrostatic carrier Cw transferred by the transfer device 50 such that the insulating layer 2 as the attraction surface for the chips C faces upwards.

In one example, the power supply 65 is located below the carrier holder 64, and has a power feed pin 65a configured to come into contact with a rear surface side, that is, the main body 1 of the electrostatic carrier Cw on the carrier holder 64 to apply a voltage thereto; a power supply source 65b configured to supply a power to the power feed pin 65a; and an earth wire 65c. In the chip placing apparatus 60, the chips C are attracted to and held on the attraction surface of the electrostatic carrier Cw by the Coulomb force generated by feeding the power from the power feed pin 65a to the main body 1. Details of the principle of the attraction of the chip C by the electrostatic carrier Cw will be described later.

Here, the location of the power supply 65 is not limited to the above example, and as long as the power supply 65 can appropriately apply a voltage to the electrostatic carrier Cw, it may be provided outside the carrier holder 64, for example, next to or above the carrier holder 64.

Further, although the present exemplary embodiment has been described for the example where the power supply 65 has only one power feed pin 65a, the power supply 65 may be equipped with a plurality of power feed pins 65a.

In one example, the charge eliminator 66 is disposed above the carrier holder 64 so as to face the holding surface of the electrostatic carrier Cw, and has an earth wire 66b for performing charge elimination (earthing) of the chips C on the electrostatic carrier Cw held by the carrier holder 64.

As an example, the charge eliminator 66 is configured to be movable above the carrier holder 64, and comes into contact with the chip C disposed at a certain position on the electrostatic carrier Cw to take the earth.

Further, the location and the structure of the charge eliminator 66 are not limited to the above example, and the charge eliminator 66 may be disposed at any position as long as the charge elimination of the chip C can be appropriately carried out.

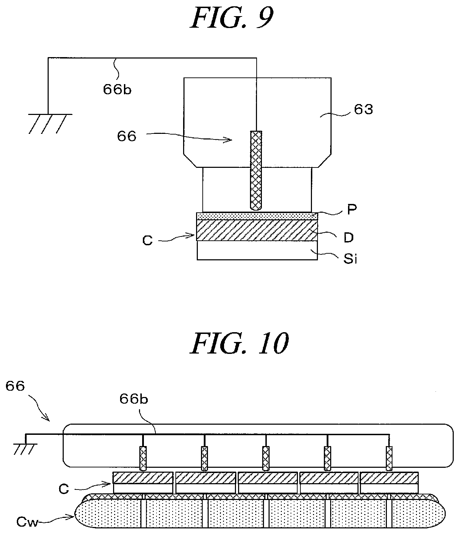

For example, the charge eliminator 66 may be prepared by burying the earth wire 66b inside the collet 63, as shown in **FIG. 9****.** In other words, the collet 63 that holds and transfers the chips C and the charge eliminator 66 that takes the earth of the chip C may be configured as one body.

In addition, as shown in **FIG. 10****,** the charge eliminator 66 may be configured to cover the entire surface of the electrostatic carrier Cw on the carrier holder 64 and perform the charge elimination (earthing) of the plurality of chips C on the electrostatic carrier Cw at the same time.

Furthermore, by forming a pad member of the collet 63 for holding and transferring the chip C as a conductor and connecting the earth wire 66b to this collet 63, the collet 63 may be configured as the charge eliminator 66. In this case, it is desirable that the pad member of the collet 63 is made of a material having a resistance value (e.g., 10e6Ω to 10e9Ω) that allows the charge elimination of the chip C to be carried out appropriately. If this resistance value is too low (less than 10e6Ω), there is a risk that the charge elimination of the chip C may not be performed appropriately. On the other hand, if the resistance value is too high (more than 10e9Ω), an abnormal discharge may occur in the holding (charge elimination) of the chip C, which may cause damage to the collet 63 and the chip C held thereby.

The alignment mechanism 67 is configured to align the electrostatic carrier Cw held by the carrier holder 64 with the chip C held by the collet 63. More specifically, the alignment mechanism 67 performs alignment between one chip C held by the collet 63 and an attracting/holding position for the chip C on the attraction surface of the electrostatic carrier Cw. The attracting/holding position for the chip C on the attraction surface of the electrostatic carrier Cw may be determined by referring to, for example, the through hole 2a formed in the insulating layer 2, or may be determined based on a previously acquired recipe or the like.

Further, the alignment mechanism 67 is capable of detecting whether the chip C has been appropriately placed on the attraction surface of the electrostatic carrier Cw. More specifically, the alignment mechanism 67 is capable of performing the alignment between the position of the chip C actually placed on the attraction surface of the electrostatic carrier Cw and a set position for the attracting/holding of the chip C within the attraction surface of the electrostatic carrier Cw.

The alignment mechanism 67 may include, by way of non-limiting example, a camera and a sensor.

The example shown in **FIG. 8** has been described for the configuration in which the chips C on the dicing tape T are transferred to the electrostatic carrier Cw one by one, for example. However, in the chip placing apparatus 60, a multiple number of chips C may be transferred onto the electrostatic carrier Cw at the same time. In this case, a multiple number of collets 63 may be arranged above the frame holder 61, or a chip transfer mechanism capable of picking up the multiple number of chips C at the same time may be provided.

In the protective film removing apparatus 70, the protective film P formed on the front surface side of the chip C is removed. Although a configuration of the protective film removing apparatus 70 is not particularly limited, the protective film removing apparatus 70 may be configured to remove the protective film P formed on the chip C by supplying a chemical liquid for etching to the protective film P (wet etching treatment) or by radiating laser light to the protective film P (ablation treatment).

In the surface modifying apparatus 80, an oxygen gas or a nitrogen gas as a processing gas is excited into plasm and ionized under, for example, a decompressed atmosphere. The oxygen ions or nitrogen ions are radiated to a front surface (device surface) of the device layer D exposed by the removal of the protective film P, and the device surface is plasma-processed and modified.

In the surface hydrophilizing apparatus 90, while rotating the electrostatic carrier Cw held on, for example, a spin chuck, pure water is supplied onto the electrostatic carrier Cw, more specifically, onto the device surface having been subjected to the surface modification. Then, the supplied pure water is diffused onto the device surface, and the device surface is hydrophilized.

In the pre-treatment apparatus 100, a pre-treatment for bonding with the chip C, such as surface activation and hydrophilization, is performed on the front surface of the wafer W (front surface of the device layer Dw) to which the chips C are yet to be bonded. The pre-treatment method for the front surface of the wafer W is the same as the pre-treatment method performed on the chips C in, for example, the surface modifying apparatus 80 and the surface hydrophilizing apparatus 90.

Further, in the processing system 10 according to the present exemplary embodiment, the pre-treatment for the chip C and the pre-treatment for the wafer W are performed in different apparatuses. However, the pre-treatment for the chip C and the pre-treatment for the wafer W may be performed in one and the same processing apparatus. That is, the pre-treatment for the wafer W may be performed in, for example, the surface modifying apparatus 80 and the surface hydrophilizing apparatus 90.

Moreover, in the processing system 10 according to the present exemplary embodiment, only one pre-treatment apparatus 100 configured to perform the pre-treatment on the wafer W is provided, and the surface activation treatment and the hydrophilization treatment are performed in this single pre-treatment apparatus 100. However, the surface activation treatment and the hydrophilization treatment may be performed in different apparatuses. That is, the processing system 10 may be provided with, instead of the pre-treatment apparatus 100, a surface modifying apparatus (not shown) and a surface hydrophilizing apparatus (not shown) configured to perform the pre-treatment on the wafer W. Likewise, the surface modifying apparatus 80 and the surface hydrophilizing apparatus 90 configured to perform the pre-treatment on the chips C may be configured as a single device.

In the bonding apparatus 110, the plurality of chips C attracted to and held by the electrostatic carrier Cw are bonded to the mounting surface of the wafer W to which the chips C are to be mounted.

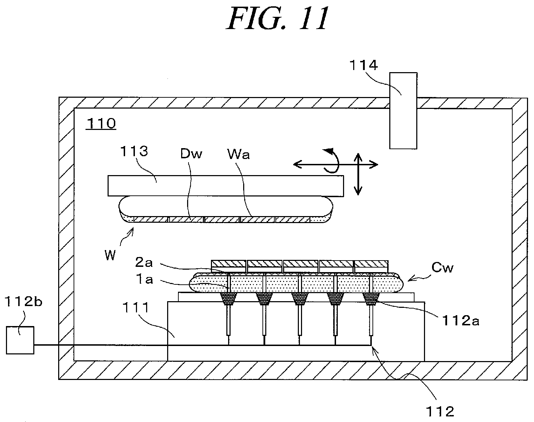

As shown in **FIG. 11****,** the bonding apparatus 110 is equipped with a carrier holder 111, an air supply 112, a wafer holder 113, and an alignment mechanism 114.

The carrier holder 111 as a second carrier holder has a holding surface for the electrostatic carrier Cw on a top surface thereof, and is configured to hold the electrostatic carrier Cw transferred by the transfer device 50, allowing the electrostatic carrier Cw attracting and holding the chips C after being subjected to the removal of the protective film P, the surface modification treatment and the surface hydrophilization treatment to face upwards.

The air supply 112 has a supply port 112a formed on the holding surface of the carrier holder 111, and an air supply source 112b connected to an end portion on the opposite side of the supply port 112a. The air supply 112 is configured to supply air from below the carrier holder 111 toward the rear surface Cb side of the chip C held on the electrostatic carrier Cw through the through hole 1a and the through hole 2a. In the bonding apparatus 110, by supplying the air to the rear surface Cb side of the chip C in this way, the chip C is lifted up from the attraction surface of the electrostatic carrier Cw, and is then separated from the attraction surface of the electrostatic carrier Cw. Details of the way to separate the chip C will be described later.

The wafer holder 113 as a substrate holder has, on a bottom surface thereof, a holding surface for the wafer W to which the chips C are to be mounted, and is configured to hold the wafer W transferred by the transfer device 50 such that the mounting surface for the chips C faces downwards. Further, in one example, the wafer holder 113 is configured to be movable horizontally and vertically and rotatable around a horizontal axis, thus allowing the top and bottom surfaces of the held wafer W to be inverted and to be moved relative to the electrostatic carrier Cw.

The alignment mechanism 114 is configured to align the electrostatic carrier Cw held by carrier the holder 111 with the wafer W held by the wafer holder 113. More specifically, the alignment mechanism 114 performs alignment between the plurality of chips C attracted to and held by the electrostatic carrier Cw and the bonding positions of the chips C on the mounting surface of the wafer W, that is, positions on the front surface Wa of the wafer W corresponding to the subdivided device layer Dw. The alignment mechanism 114 may include, by way of non-limiting example, a camera and a sensor.

In addition, although the carrier holder 111 is fixed to a bottom side of the bonding apparatus 110 and the wafer holder 113 is disposed above the carrier holder 111 in the shown example, the carrier holder 111 may be fixed to a top side of the bonding apparatus 110 and the wafer holder 113 may be disposed below the carrier holder 111. In other words, in the bonding apparatus 110, the plurality of chips C attracted to and held on the attraction surface of the electrostatic carrier Cw may be held by the carrier holder 111 such that they face downwards, and the wafer W may be held by the wafer holder 113 such that its mounting surface for the chips C faces upwards.

The above-described processing system 10 is equipped with a control device 120. The control device 120 is, for example, a computer equipped with a CPU and a memory, and has a program storage (not shown). The program storage stores therein a program for controlling the chip-on-wafer manufacturing process in the processing system 10. Further, the program may have been recorded on a computer-readable recording medium H, and may be installed into the control device 120 from the recording medium H. In addition, the recording medium H may be transitory or non-transitory.

The processing system 10 according to the exemplary embodiment is configured as described above. However, other processing devices may be further provided in the processing system 10 depending on the purpose concerned, and some processing devices may be disposed outside the processing system 10 depending on the purpose concerned.

Specifically, the processing system 10 may be further equipped with various types of devices configured to thin the silicon layer Si formed on the rear surface Cb side of the chip C.

In addition, the pre-treatment apparatus 100 configured to perform the pre-treatment on the wafer W may be omitted from the processing system 10, and a wafer W that has been previously subjected to the pre-treatments (surface activation treatment and hydrophilization treatment) outside the processing system 10 may be carried into the processing system 10 while being carried in the FOUP Fw.

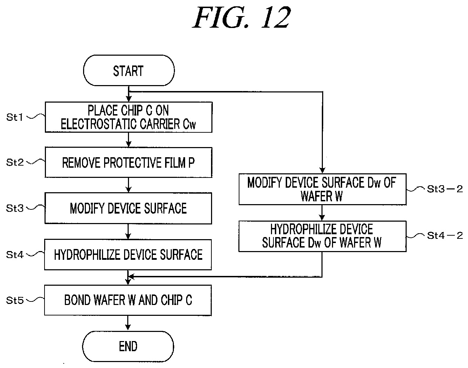

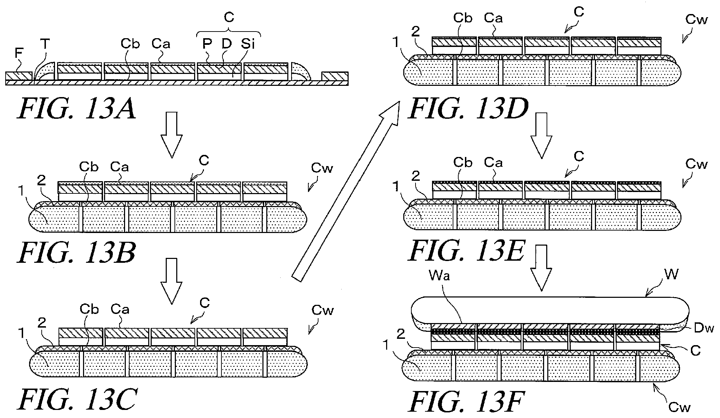

Now, the chip-on-wafer manufacturing process performed in the processing system 10 configured as described above will be explained. **FIG. 12** is a flowchart showing main processes of the chip-on-wafer manufacturing process. **FIG. 13A** to **FIG. 13F** are explanatory side views schematically illustrating some of the processes of the chip-on-wafer manufacturing process.

First, the FOUPs Ff, Fc, and Fw accommodating therein the multiple number dicing frames F, the multiple number of electrostatic carriers Cw, and the multiple number of wafers W, respectively, are placed on the FOUP placement table 20 of the carry-in/out station 11.

As depicted in **FIG. 13A****,** the dicing frame F accommodated in the FOUP Ff has the dicing tape T fixed thereto, and this dicing tape T has the plurality of chips C attached thereto. The silicon layer Si on the rear surface Cb side of each of the plurality of chips C is attached to the dicing tape T.

Then, the dicing frame F in the FOUP Ff is taken out by the transfer device 30, and is transferred to the transition device 40. The dicing frame F sent to the transition device 40 is then transferred to the chip placing apparatus 60 by the transfer device 50. Concurrently or subsequently, the electrostatic carrier Cw in the FOUP Fc is transferred to the chip placing apparatus 60.

In the chip placing apparatus 60, the chip C whose rear surface Cb side is attached to the adhesive surface of the dicing tape T is placed at the position corresponding to the holding position within the attraction surface of the electrostatic carrier Cw such that the rear surface Cb side faces downwards, and is attracted and held, as shown in **FIG. 13B** (process St1 in **FIG. 12****).**

Hereinafter, an example of an operation of placing the chip C on the electrostatic carrier Cw in the chip placing apparatus 60 will be described (see **FIG. 8****).**

First, the frame holder 61 and the pusher 62 are moved horizontally relative to each other, and the pusher 62 is moved to below one chip C among the plurality of chips C attached to the dicing tape T. Then, the one chip C is selectively pushed up and raised from below (rear surface Cb side) by the pusher 62.

Then, the front surface Ca of the one chip C that has been pushed up is held from above by the collet 63. At this time, since the protective film P is formed on the front surface Ca side of the chip C, the device layer D is not damaged by the holding, for example, attraction holding by the collet 63.

Next, the collet 63 holding the chip C is moved to a position corresponding to one of the attraction holding positions in the electrostatic carrier Cw on the carrier holder 64, the chip C is placed on the attraction surface of the electrostatic carrier Cw, and the holding of the chip C by the collet 63, for example, attraction of the chip C is released.

Subsequently, by using the alignment mechanism 67, it is detected whether the chip C has been properly placed at the one attraction holding position. As a result of the detection, if it is determined that the chip C is properly placed, the operation of placing the next chip C on the dicing tape T is started. On the other hand, if it is determined that the chip C is not properly placed, the placed chip C is re-held by the collet 63, and repositioning of the chip C at the one attraction holding position is performed.

Finally, the power feed pin 65a of the power supply 65 is brought into contact with the main body 1 of the electrostatic carrier Cw, the voltage is applied to the electrostatic carrier Cw through the power feed pin 65a, and the chip C is attracted and held on the attraction surface of the electrostatic carrier Cw by the generated Coulomb force.

The electrostatic attraction of the chip C by the electrostatic carrier Cw will be described in further detail.

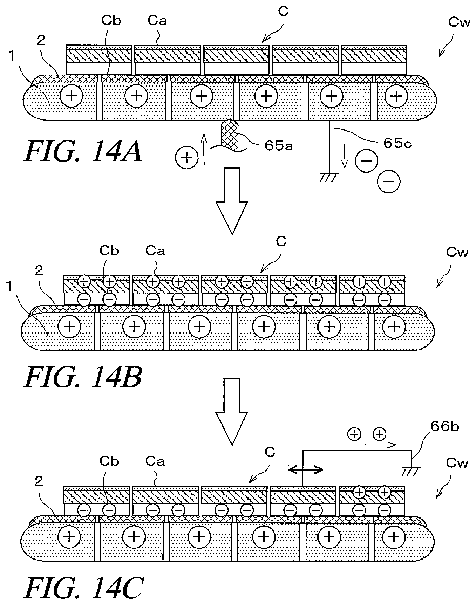

When all the chips C are placed at the attraction holding positions of the electrostatic carrier Cw by the collet 63, a voltage (positive (+) charges in the shown example) is applied to the electrostatic carrier Cw through the power feed pin 65a, so the main body 1 of the electrostatic carrier Cw is charged positively (+), as illustrated in **FIG. 14A****.**

Once the main body 1 is charged positively (+), electric charges of the opposite polarity (i.e., negative (-)) to the electric charges accumulated in the main body 1 are accumulated on the rear surface Cb side of the chip C with the insulating layer 2 therebetween, and, also, electric charges of the same polarity (i.e., positive (+)) as the electric charges accumulated in the main body 1 are accumulated on the front surface Ca side of the chip C, as shown in **FIG. 14B****.**

Subsequently, the earth wire of the charge eliminator 66 is brought into contact with the front surface Ca side (opposite side of the rear surface Cb, which is the holding surface) of the chip C. As a result, in the chip C, the positive charges on the front surface Ca side are discharged (earthed) while the negative charges that are attracted to the positive charges of the main body 1 are left, as illustrated in **FIG. 14C****.**

When the charge eliminator 66 is retreated thereafter, a potential difference is generated between the main body 1 of the electrostatic carrier Cw and the chip C with the insulating layer 2 therebetween, thereby generating an electrostatic force to attract each other. As a result, the chip C is attracted to the attraction surface of the electrostatic carrier Cw by the electrostatic force.

As stated above, in the exemplary embodiment of the present disclosure, the main body 1 of the electrostatic carrier Cw acts similarly as a unipolar electrode, and the chip C can be attracted to and held on the attraction surface with the insulating layer 2 in between without forming an electrode wiring pattern inside the main body 1. That is, the insulating layer 2 serves to maintain the electric charges accumulated in the main body 1 by insulating the electric charges applied to the main body 1.

In addition, in the electrostatic carrier Cw according to the exemplary embodiment of the present disclosure, the insulating layer 2 is made of a flexible material with a low elastic modulus.

After the chip C is placed on the electrostatic carrier Cw but before the chip C is attracted and held by the electrostatic force, a gap exists between the silicon layer Si of the chip C and the insulating layer 2 of the electrostatic carrier Cw. Due to the flexibility of the insulating layer 2, when the chip C is attracted by the electrostatic force in the electrostatic carrier Cw, air is released from between the silicon layer Si of the chip C and the insulating layer 2, which serves as the attraction surface, by the force of the chip C being attracted to the insulating layer 2, so that a pseudo-vacuum state is formed between the chip C and the insulating layer 2.

As a result, in addition to the electrostatic attraction by the electrostatic force, a vacuum-attracting force formed by the pseudo-vacuum state is exerted between the electrostatic chuck Cw and the chip C, so that a strong holding state using both the electrostatic attracting force and the vacuum-attracting force is created.

The electrostatic attraction of the chip C by the electrostatic carrier Cw is performed as described above.

In addition, the operation of placing the chip C on the electrostatic carrier Cw may be sequentially performed one by one for each of the plurality of chips C attached on the dicing tape T, or the plurality of chips C on the dicing tape T may be placed on the electrostatic carrier Cw simultaneously.

Further, the timing of the voltage application to the main body 1 and the timing of the earthing of the chips C are not limited to the above-described example. As another example, the voltage may be applied to the main body 1 in advance prior to the placement of the chips C on the attraction surface (in a state where no chip C is present on the electrostatic carrier Cw), and the voltage may be applied after the placement of the chips C on the attraction surface (after all the chips C are placed on the electrostatic carrier Cw) as shown in **FIG. 14A** to **FIG. 14C****.** Furthermore, in the case where the plurality of chips C are simultaneously placed on the electrostatic carrier Cw, the voltage may be applied to the main body 1 at the moment when the chips C are placed on the attraction surface. In addition, the charge elimination (earthing) of the chip C on the electrostatic carrier Cw may be performed at the same time as the chip C is placed on the attraction surface and the voltage is applied, or may be performed after the chip C is completely placed on the attraction surface and the voltage is applied to attract and hold the chip C.

However, if the voltage is applied to the main body 1 in a state where no chip C is placed on the attraction surface, there is a risk that particles may be attracted to and attached to the attraction surface due to the generated electrostatic force. Taking this into account, the timing of the voltage application to the main body 1 is desirably after the placement of the chip C on the attraction surface, or concurrently with the placement of the chip C on the attraction surface. More desirably, it is desirable that the voltage application to the main body 1 is performed after all the chips C are placed on the electrostatic carrier Cw.

In addition, in the chip placing apparatus 60, it may be checked by using the alignment mechanism 67 whether or not the chips C are properly placed, and the repositioning of the chips C may be performed when necessary, as stated above. For example, in the case of bonding the chips C to the wafer W one by one in the bonding apparatus 110 to be described later, high alignment precision is not required in the chip placing apparatus 60, and it may be sufficient that the chips C do not interfere with each other. That is, in the case of bonding the chips C one by one in the bonding apparatus 110, the alignment precision in the chip placing apparatus 60 is not required, and it may be sufficient that the chips C can be precisely aligned with the mounting positions on the wafer W to be bonded thereto in a bonding process in the bonding apparatus 110 to be described later.

Once the chips C are placed on the electrostatic carrier Cw, the electrostatic carrier Cw holding the chips C is then transferred to the protective film removing apparatus 70 by the transfer device 50. In the protective film removing apparatus 70, the protective film P formed on the device layer D of the chip C is removed, as shown in **FIG. 13C** (process St2 in **FIG. 12****).**

Here, when a conductive liquid (for example, an etching liquid in the protective film removing apparats 70) is used to remove the protective film P, there is a risk that the electric charges accumulated in the electrostatic carrier Cw or in the chip C may leak through the conductive liquid as stated above, causing the electrostatic attracting force of the chip C for the electrostatic carrier Cw to be lost.

In this regard, in the electrostatic carrier Cw according to the exemplary embodiment of the present disclosure, the vacuum-attracting force as well as the electrostatic attracting force is generated between the electrostatic carrier Cw and the chip C in order to perform the attracting and holding of the chip. Thus, in the electrostatic carrier Cw according to the exemplary embodiment of the present disclosure, even when the electrostatic attracting force between the electrostatic carrier Cw and the chip C is lost, the attracting and holding of the chip C can be maintained by the vacuum-attracting force.

These effects are the same in the surface modifying treatment and the hydrophilizing treatment to be described later.

In addition, especially since the dicing tape T holds the chip C with its adhesive surface facing upwards, when the protective film P is removed while the chip C is attached to the dicing tape T as in a conventional method, there arises a risk that the dicing tape T may be damaged as described above, which in turn makes it difficult to maintain the holding of the chip C by the dicing tape T or to reuse the dicing tape T.

Meanwhile, in the chip-on-wafer manufacturing process according to the exemplary embodiment of the present disclosure, the removal of the protective film P is performed on the chip C that is held on the electrostatic carrier Cw instead of the dicing tape T. In the present exemplary embodiment, the electrostatic carrier Cw is formed by combining the main body 1 such as silicon or aluminum having chemical tolerance, and the insulating layer 2 such as a polyimide film or a back grind tape having chemical tolerance. Therefore, in the removal of the protective film P, the damage to the electrostatic carrier Cw can be suppressed as compared to the damage to the dicing tape T, so that the dicing tape T fixed to the dicing frame F can be reused, and, furthermore, the electrostatic carrier Cw can also be used repeatedly.

These effects are the same in the surface modifying treatment and the hydrophilizing treatment to be described later.

Next, the electrostatic carrier Cw holding the chip C from which the protective film P has been removed is transferred to the surface modifying apparatus 80 by the transfer device 50. In the surface modifying apparatus 80, the device surface exposed on the front surface Ca side of the chip C is modified by being plasma-processed, as illustrated in **FIG. 13D** (process St3 in **FIG. 12****).**

Thereafter, the electrostatic carrier Cw holding the chip C whose device surface has been modified is transferred to the surface hydrophilizing apparatus 90 by the transfer device 50. In the surface hydrophilizing apparatus 90, as shown in **FIG. 13E****,** a hydroxyl group (silanol group) is attached on the device surface of the chip C modified in the surface modifying apparatus 80, so that the device surface is hydrophilized. Also, the electrostatic carrier Cw and the chip C are cleaned by the pure water (process St4 in **FIG. 12****).**

In addition, following, concurrently with, or prior to the surface modification of the chip C in the surface modifying apparatus 80 in the process St3 and the hydrophilization of the chip C in the surface hydrophilizing apparatus 90 in the process St4, the wafer W in the FOUP Fw is transferred to the pre-treatment apparatus 100. In the pre-treatment apparatus 100, the surface modification treatment and the hydrophilization treatment are performed on the device layer Dw on the front surface Wa side of the wafer W in the same manner as in the surface modification treatment and the hydrophilization treatment on the chip C (processes St3-2 and St4-2 in **FIG. 12****).**

Next, the electrostatic carrier Cw holding the chip C whose device surface has been hydrophilized is transferred to the bonding apparatus 110 by the transfer device 50. Concurrently with this or subsequently thereafter, the wafer W whose front surface Wa side (device layer Dw) has been hydrophilized is transferred to the bonding apparatus 110.

In the bonding apparatus 110, as illustrated in **FIG. 13F****,** the plurality of chips C on the electrostatic carrier Cw and the mounting surface (pre-treated front surface Wa) of the wafer W on which the chips C are to be mounted are overlapped and pressed from a vertical direction, so that the chips C are bonded to the wafer W (so-called fusion bonding) (process St5 of **FIG. 12****).**

Hereinafter, an example of a bonding operation of bonding the chips C to the wafer W in the bonding apparatus 110 will be described (see **FIG. 11****)**

First, the electrostatic carrier Cw, which is attracting and holding the plurality of chips C, is placed on the carrier holder 111 with its attraction surface facing upwards, that is, with the plurality of chips C facing upwards.

Then, the wafer holder 113 holding the wafer W is placed above the electrostatic carrier Cw. The wafer W is held by the wafer holder 113 with its front surface Wa, which is the pre-treated mounting surface for the chips C, facing downwards. At this time, the wafer W held by the wafer holder 113 is aligned by the alignment mechanism 114 such that the positions of the subdivided device layer Dw on the mounting surface of the wafer W correspond to the positions of the plurality of chips C on the electrostatic carrier Cw, respectively. In the chip placing apparatus 60, the high-precision alignment and the repositioning of the chips C with respect to the electrostatic carrier Cw are performed to align the chips C on the electrostatic carrier Cw with the device layer Dw on the wafer W.

Next, the chips C on the electrostatic carrier Cw held by the carrier holder 111 and the device layer Dw on the wafer W held by the wafer holder 113 are pressed from the vertical direction, thus allowing the chips C and the device layer Dw to be bonded to each other.

At this time, Since the device layer Dw of the wafer W and the device surfaces of the respective chips C on the electrostatic carrier Cw are modified, a van der Waals force (intermolecular force) is generated between the device layer Dw and the device surfaces of the chips C, so that the device layer Dw of the wafer W and the chips C on the electrostatic carrier Cw are bonded. In addition, since the device layer Dw and the device surfaces of the respective chips C are hydrophilized, the hydrophilic groups between the device layer Dw and the chips C are hydrogen-bonded (intermolecular force), so that the device layer Dw of the wafer W and the chips C on the electrostatic carrier Cw are firmly bonded.

Once the device layer Dw of the wafer W and the chips C on the electrostatic carrier Cw are bonded, air pressure is applied to the rear surface Cb side of the chips C on the electrostatic carrier Cw through the through holes 1a and 2a from the supply port 112a of the air supply 112, thereby reducing the adhesion between the chips C and the insulating layer 2 on the attraction surface of the electrostatic carrier Cw.

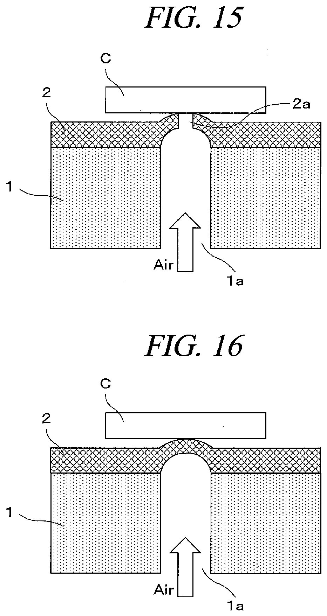

More specifically, when the air is supplied to the rear surface Cb side of the chip C, the insulating layer 2 expands with a center portion of the through hole 1a formed in the main body 1 directly under the chip C as a peak, as shown in **FIG. 15****,** since the through hold 2a formed in the insulating layer 2 is blocked by the chip C. Then, while a close contact between the chip C and the insulating layer 2 is maintained at the center of the chip C corresponding to the center portion of the through hole 1a, the chip C rises from the insulating layer 2 at an outer peripheral portion thereof corresponding to a peripheral portion of the through hole 1a. As a result, the adhesion between the chip C and the insulating layer 2 is reduced, more specifically, it is reduced as compared to the bonding strength between the chip C and the device layer Dw of the wafer W.

In addition, even if the through hole 2a is not formed in the insulating layer 2 as described above, by supplying the air to the rear surface Cb side of the chip C via the through hole 1a, the insulating layer 2 can also be expanded to reduce the adhesion between the chip C and the insulating layer 2, as illustrated in **FIG. 16****.**

Furthermore, according to the exemplary embodiment of the present disclosure, both the electrostatic attracting force and the vacuum-attracting force are applied between the chip C and the insulating layer 2 as stated above. Therefore, even when the through hole 2a of the insulating layer 2 and the through hole 1a of the main body 1 are formed to have the same diameter as mentioned above, the chip C is suppressed from flying away due to the breakdown of the vacuum attraction between the chip C and the insulating layer 2 (injection of air from the through hole 1a to below the chip C) when the air is supplied to reduce the adhesion between the chip C and the insulating layer 2.

Next, the wafer holder 113 holding the wafer W is raised. As a result, since the adhesion between the chip C and the insulating layer 2 is reduced, the chip C is completely separated from the insulating layer 2.

Finally, the wafer holder 113 is rotated around a horizontal axis, whereby the front and rear surfaces of the wafer W are inverted. In other words, the mounting surface of the wafer W on which the plurality of chips C are bonded is turned to face upwards.

The bonding operation of bonding the chips C to the wafer W according to the exemplary embodiment is performed as described above.

Further, the electrostatic carrier Cw attracting and holding the plurality of chips C as described above may be held such that its attraction surface faces downwards, that is, such that the plurality of chips C face downwards, and the wafer W may be disposed below the electrostatic carrier Cw. In other words, the arrangement of the electrostatic carrier Cw and the wafer W in the vertical direction is not limited to the shown example, and they may be held and transferred with their positions reversed in the vertical direction.

After the plurality of chips C are bonded to the device layer Dw of the wafer W, the wafer W on which the chips C are mounted is transferred to the transition device 40 by the transfer device 50, and is then transferred to the FOUP Fw of the FOUP placement table 20 by the transfer device 30.

Likewise, the electrostatic carrier Cw from which the chips C have been separated is transferred to the transition device 40 by the transfer device 50, and is then transferred to the FOUP Fc of the FOUP placement table 20 by the transfer device 30. In this way, the series of chip-on-wafer manufacturing processes in the processing system 10 are completed.

In addition, the FOUPs into which the dicing frame F, the electrostatic carrier Cw, and the wafer W are recovered need not necessarily be the same FOUPs that have once housed the dicing frame F, *etc.,* when they are carried in. That is, the FOUPs that have accommodated the dicing frame F, *etc.,* may each carry out different members, or a new FOUP for carrying out the dicing frame F, *etc.,* may be carried into the processing system 10.

According to the above-described exemplary embodiment, in the series of chip-on-wafer manufacturing processes, the electrostatic carrier Cw that serves as a relay member for transferring the chips C from the dicing tape T onto the wafer W can be configured to have a simple structure in which the insulating layer 2 is formed on the front surface of the conductive main body 1.

Also, due to this simple structure, there is no need to form the electrode wiring pattern inside the conductive main body, unlike in a conventional electrostatic carrier. Therefore, the degree of freedom in forming the through holes for use in separating the chips C is also improved greatly, so that the effort and cost associated with configuring the electrostatic carrier Cw can also be greatly reduced.

More specifically, in the structure of the conventional electrostatic carrier (electrostatic holding mechanism), a through hole required to separate a holding target object needs to be formed directly under the holding target object, and arranged to avoid a wiring pattern of an embedded electrode for attracting and holding the holding target object. In addition, depending on the number and the layout of target objects to be held together, it has been necessary to change the layout of through holes or wiring pattern, which requires a great amount of effort and cost.

In the electrostatic carrier Cw according to the exemplary embodiment of the present disclosure, however, since there is no need to configure the electrode wiring pattern inside the conductive main body, the number and the layout of the through holes can be selected as required.

Further, in the electrostatic carrier Cw according to the exemplary embodiment of the present disclosure, the insulating layer 2 formed on the front surface of the main body 1 is made of a material having flexibility with a low elastic modulus. As a result, the air is released from between the insulating layer 2 and the chip C, so the pseudo-vacuum-attracting force is generated in addition to the electrostatic attracting force generated by the application of the voltage to the main body 1. Therefore, the attracting and holding of the chip C can be more appropriately carried out.

Since the vacuum-attracting force as well as the electrostatic attracting force can be generated, even when the electrostatic attracting force between the electrostatic carrier Cw and the chip C is lost as a result of supplying the conductive liquid onto the electrostatic carrier Cw when performing, for example, the removal of the protective film P, the holding force for the chip C can be appropriately maintained.

Further, in the electrostatic carrier Cw according to the present embodiment, by forming the insulating layer 2 on the front surface of the main body 1 with the material having flexibility with the low elastic modulus as stated above, the insulating layer 2 can be easily expanded by the supply of the air when the chip C is separated, so that the attracting force between the chip C and the insulating layer 2 can be appropriately reduced.

Furthermore, the electrostatic carrier Cw according to the present exemplary embodiment is configured to have approximately the same diameter as the wafer W on which the chips C are to be mounted, as stated above. This makes it possible to transfer and process the electrostatic carrier Cw by using the same transfer device and processing device as for the wafer W. Thus, there is no need to newly provide a device for transferring and processing the electrostatic carrier Cw.

Additionally, in the bonding apparatus 110 according to the exemplary embodiment, the plurality of chips C are mounted on the wafer W at the same time by bringing the electrostatic carrier Cw on the carrier holder 111 and the wafer W on the wafer holder 113, which are arranged to face each other, into contact with each other. However, the mounting of the chips C onto the wafer W may be performed one by one for the chips C.

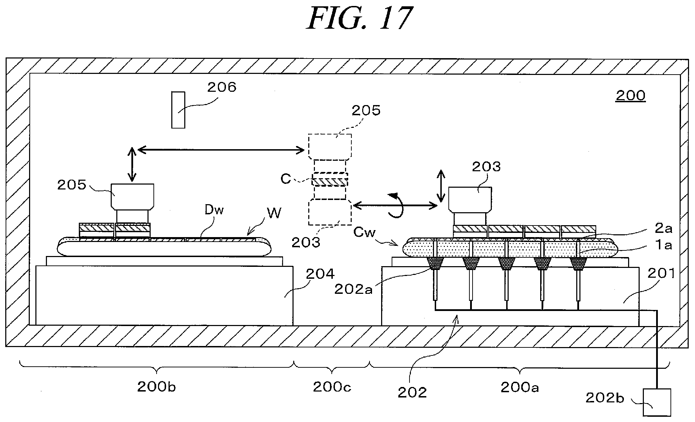

As illustrated in **FIG. 17****,** a bonding apparatus 200 according to another exemplary embodiment for mounting the chips C on the wafer W one by one has a separation area 200a, a bonding area 200b, and a delivery area 200c formed therein. In the separation area 200a, the chips C are picked up from the electrostatic carrier Cw. In the bonding area 200b, the chips C are bonded to the wafer W. In the delivery area 200c, the chips C are delivered between the separation area 200a and the bonding area 200b.

The separation area 200a is provided with a carrier holder 201 as a second carrier holder, an air supply 202, and a first collet 203.

The carrier holder 201 and the air supply 202 have approximately the same configurations as the carrier holder 111 and the air supply 112 of the bonding apparatus 110 according to the above-described exemplary embodiment. The air supply 202 has a supply port 202a and an air supply source 202b, and supplies air toward the rear surface Cb side of each chip C held on the electrostatic carrier Cw through the through hole 1a and the through hole 2a.

In this bonding apparatus 200 according to another exemplary embodiment, the air from the air supply source 202b is supplied independently to each of the chips C attracted to and held on the electrostatic carrier Cw, in other words, independently to each of the plurality of through holes 1a formed in the main body 1. In this case, it is desirable that the air supply 202 is provided with control valves (not shown) for independently supplying the air to the chips C, respectively.

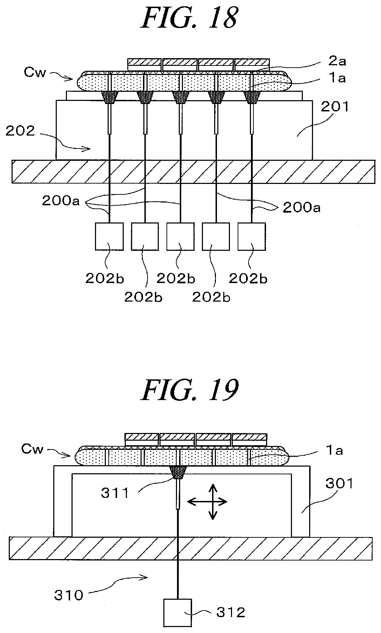

In addition, in the bonding apparatus 200 according to another exemplary embodiment, any configuration in which the air from the air supply source 202b can be independently supplied to each of the chips C attracted to and held on the electrostatic carrier Cw may be adopted. For example, the common air supply source 202b may be connected to the plurality of supply ports 202a, as shown in **FIG. 17****,** or a plurality of air supply sources 202b may be connected to the plurality of supply ports 202a in one-to-one correspondence, as shown in **FIG. 18****.** In other words, one or more air supply sources 202b may be disposed in the bonding apparatus 200.

The first collet 203 is disposed above the carrier holder 201. The first collet 23 serves to hold the chip C whose adhesion to the insulating layer 2 is reduced due to the supply of the air from the air supply 202 and whose outer peripheral portion has thus risen, separates this chip C from the electrostatic carrier Cw, and transfers the held chip C between the separation area 200a and the delivery area 200c. In addition, in one example, the first collet 203 is configured to be rotatable around a horizontal axis, and is capable of inverting top and bottom surfaces of the held chip C as illustrated.

Further, the top surface side of the chip C held by the first collet 203 in the bonding apparatus 200 is a device surface where the device layer D is exposed by the removal of the protective film P as described above. Therefore, it is necessary to hold the chip C by the first collet 203 so as not to damage this exposed device surface.

Specifically, it is desirable to use, as the first collet 203, a non-contact chuck capable of holding the chip C from above without coming into contact with the chip C by using, for example, the Bernoulli effect or the ultrasonic squeeze effect.

Alternatively, the first collet 203 may be configured to hold, for example, a side surface of the chip C that has been lifted by the supply of the air, instead of holding the top surface (device surface) of the chip C.

The bonding area 200b is provided with a wafer holder 204, a second collet 205, and an alignment mechanism 206.

The wafer holder 204 as a substrate holder has, on a top surface thereof, a holding surface for the wafer W, and holds the wafer W transferred by the transfer device 50 such that the formation surface of the device layer Dw, which is the mounting surface where the chips C are to be mounted, faces upwards.

The second collet 205 is positioned above the wafer holder 204 to hold the chip C held by the first collet 203 from above and transfer the held chip C between the bonding area 200b and the delivery area 200c.

Also, in one example, the second collet 205 may be configured to be rotatable around a horizontal axis instead of the first collet 203. In this case, the second collet 205 holds the chip C held by the first collet 203 from below in the delivery area 200c, inverts the top and bottom surfaces of the chip C, and then bonds the chip C to the wafer W in the bonding area 200b.

Further, in the bonding apparatus 200, no device layer is exposed on the rear surface Cb side of the chip C held by the second collet 205, unlike the front surface Ca side held by the first collet 203. Therefore, the second collet 205 does not necessarily need to be composed of a non-contact chuck or the like, unlike the first collet 203.

The alignment mechanism 206 has, in one example, the same configuration as the alignment mechanism 67 of the chip placing apparatus 60. That is, the alignment mechanism 206 is equipped with, by way of example, a camera, a sensor, and the like, and aligns the positions of the wafer W held by the wafer holder 204 and the chip C held by the second collet 205.

The bonding apparatus 200 according to another exemplary embodiment is configured as described above. Hereinafter, an example method of bonding the chips C to the wafer W by using the bonding apparatus 200 will be explained.

In the bonding of the chips C to the wafer W in the bonding apparatus 200, first, the electrostatic carrier Cw attracting and holding the plurality of chips C thereon is placed on the carrier holder 201 with the plurality of chips C facing upwards. Then, the wafer W on which the chips C are to be mounted is placed on the wafer holder 204 with the formation surface of the device layer Dw facing upwards.

Next, by selectively supplying air to the through hole 1a corresponding to one chip C to be separated, the insulating layer 2 is expanded to push up the chip C from below, allowing the chip C to rise.

Next, the chip C that has risen is lifted up by being held by the first collet 203 such that the device surface should not be damaged. The holding of the chip C by the first collet 203 may be performed before the chip C is lifted by the air, or may be performed at the same time as the chip C is lifted by the air.

Subsequently, the first collet 203 is rotated around the horizontal axis, thereby allowing the front and rear surfaces of the chip C to be inverted. In other words, the rear surface Cb (the side opposite to the device surface) of the chip C held by the first collet 203 is turned to face upwards.

Thereafter, the rear surface Cb of the chip C held by the first collet 203 is held from above by the second collet 205, and, also, the holding of the front surface Ca side of the chip C by the first collet 203 is released. In other words, grip changing of the chip C is performed so that the chip C once held by the first collet 203 is held by the second collet 205.

Then, the second collet 205 holding the chip C is moved to a position corresponding to one device layer Dw on the mounting surface of the wafer W. The alignment of the second collet 205 and the device layer Dw is appropriately performed by using the alignment mechanism 206.

Finally, the device surface of the chip C held by the second collet 205 and the one device layer Dw of the wafer W are pressed from a vertical direction, so that the chip C and the device layer Dw are bonded.

The bonding operation of the chip C to the wafer W according to another exemplary embodiment is performed as described above. This bonding operation of the chip C is performed independently and subsequently for each of the plurality of chips C that are attracted to and held on the electrostatic carrier Cw.

In addition, in the above exemplary embodiment, by selectively supplying the air to the through hole 1a corresponding to the one chip C as a target of separation, only the one chip C is pushed up from below and raised. However, when air cannot be supplied independently to each of the through holes 1a (for example, when no control valve is provided), air may be supplied to all the through holes 1a in advance to make all the chips C rise, and, then, the chips C may be sequentially picked up by the first collet 203.

Alternatively, as in a carrier holder 301 shown in **FIG. 19****,** for example, there may be adopted an air supply 310 having only one supply port 311 for all of the plurality of chips C in common. An air supply source 312 is connected to the supply port 311.

In this case, it is desirable that the carrier holder 301 and the one supply port 311 are configured to be horizontally movable relative to each other. As long as the carrier holder 301 and the supply port 311 can be horizontally moved relative to each other, it may be sufficient that at least one of the carrier holder 301 and the supply port 311 is configured to be movable.

In the carrier holder 301, by supplying air from the supply port 311 to the entire bottom surface of the electrostatic carrier Cw held by the carrier holder 301, all of the plurality of chips C held by the electrostatic carrier Cw may be separated from the electrostatic carrier Cw at once. Alternatively, the carrier holder 301 and the supply port 311 may be horizontally moved relative to each other to locate the supply port 311 under one chip C among the plurality of chips C, and by supplying the air to the one chip C selectively, the one chip C may be selectively separated from the electrostatic carrier Cw.

In addition, the bonding apparatus according to the above-described exemplary embodiments has been described for an example where the chips C held on the electrostatic carrier Cw are separated by supplying air from the air supply to the electrostatic carrier Cw on the carrier holder. However, the method of separating the chips C held on the electrostatic carrier Cw is not limited thereto. By way of example, instead of supplying air, a lift pin (not shown) may be inserted through the through hole 1a from below the electrostatic carrier Cw, and a leading end of this lift pin may be configured to be protruded and retracted from the top surface (upper end of the through hole 1a) of the main body 1 of the electrostatic carrier Cw. In this case, the lift pin comes into contact with the bottom surface of the chip C held on the electrostatic carrier Cw through the through hole 1a, so that the chip C is lifted up and separated from the electrostatic carrier Cw.

In addition, in the bonding apparatus according to the above-described exemplary embodiment, the chip C is separated by supplying the air to the bottom surface of the chip C from below the electrostatic carrier Cw or by bringing the lift pin into contact with the bottom surface of the chip C from below the electrostatic carrier Cw. However, it may also be possible to configure the chip C to be separated from the electrostatic carrier Cw by using only the collet at the upper side (corresponding to the first collet in the above-described exemplary embodiments) without applying the force from below the chip C on the electrostatic carrier Cw.

Specifically, in addition to the pickup by the collet, a centrifugal force accompanying the rotation of the spin chuck in the surface modifying apparatus 80 or the surface hydrophilizing apparatus 90, a stress accompanying the flow of the conductive liquid, or an inertial force accompanying the transfer of the electrostatic carrier Cw are assumed as a stress acting on the chip C on the electrostatic carrier Cw. Among these, while the stress accompanying the pickup by the collet acts in an up-and-down direction (vertical direction) with respect to the chip C, the centrifugal force, the flow force, and the inertial force are shear forces acting in a horizontal direction. From this point of view, by making a holding force for the chip C by the electrostatic carrier Cw strong in the horizontal direction (with respect to a shear stress) and weak in the vertical direction (with respect to a tensile force), it may be possible to separate the chip C from the electrostatic carrier Cw only by holding it by the collet without performing the supply of the air or the lifting by the lift pin.

It should be noted that the above-described exemplary embodiments are illustrative in all aspects and are not anyway limiting. The above-described exemplary embodiments may be omitted, replaced and modified in various ways without departing from the scope and the spirit of claims. For example, the constitutional elements of the above-described exemplary embodiments may be combined in various ways. From any of these various combinations, functions and effects for the respective constituent elements are naturally obtained, and other functions and other effects obvious to those skilled in the art are also obtained from the description of the present specification.

In addition, the effects described in the present specification are only explanatory or illustrative and are not limiting. That is, the technique according to the present disclosure may exhibit, together with or instead of the above-stated effects, other effects obvious to those skilled in the art from the description of the present specification.

For example, in the above-described exemplary embodiment, the chip placing apparatus 60 and the bonding apparatus 110 are disposed in the same processing system 10. However, these chip placing apparatus 60 and bonding apparatus 110 may be respectively disposed in different processing systems. In other words, a first processing system for placing the chips C on the dicing frame F on the electrostatic carrier Cw, and a second processing system for bonding the chips C on the electrostatic carrier Cw onto the wafer W may be configured independently.

### EXPLANATION OF CODES

1: Main body
1a: Through hole
2: Insulating layer
Cw: Electrostatic carrier

## Claims

1. An electrostatic carrier, comprising:
a main body having conductivity and provided with multiple through holes in a thickness direction thereof; and
an insulating layer formed on a front surface of the main body.

2. The electrostatic carrier of Claim 1,
wherein the main body is a conductive substrate made of silicon, aluminum, an aluminum alloy, stainless steel or titanium.

3. The electrostatic carrier of Claim 1,
wherein the insulating layer is made of a material having an elastic modulus of 2 GPa or less, desirably, 0.5 GPa or less.

4. The electrostatic carrier of Claim 3,
wherein the insulating layer is a polyimide film formed by spin coating on the front surface of the main body.

5. The electrostatic carrier of Claim 3,
wherein the insulating layer is an insulating film formed by attaching a polyimide film or back grind tape to the front surface of the main body.

6. The electrostatic carrier of Claim 3,
wherein the insulating layer has a second through hole at a position corresponding to each of the multiple through holes.

7. The electrostatic carrier of Claim 6,
wherein the second through hole is formed with a smaller diameter as compared to the corresponding through hole.

8. A processing system configured to process multiple chips, comprising:
a chip placing apparatus configured to pick up each of the multiple chips and place the corresponding chip on an attraction surface of an electrostatic carrier as claimed in any one of Claims 1 to 7,
wherein the chip placing apparatus comprises:
a carrier holder having a holding surface for the electrostatic carrier on a top surface thereof;
a power supply configured to supply power to the main body of the electrostatic carrier on the carrier holder; and
a charge eliminator configured to come into contact with the chip on the electrostatic carrier to take earth.

9. The processing system of Claim 8,
wherein the charge eliminator has an earth wire to be brought into contact with the chip, so as to face the holding surface for the electrostatic carrier on the carrier holder.

10. The processing system of Claim 8, further comprising:
a collet configured to pick up the chip and transfer the chip onto the electrostatic carrier on the carrier holder,
wherein an earth wire of the charge eliminator, which is to be brought into contact with the chip, is configured as one body with the collet.

11. The processing system of Claim 8,
wherein the charge eliminator is configured by a collet configured to pick up the chip and transfer the chip onto the electrostatic carrier on the carrier holder, and
the collet has a resistance value of 10e6Ω to 10e9Ω.

12. The processing system of Claim 8, further comprising:
a chip transfer mechanism configured to hold and transfer the multiple chips all at once onto the electrostatic carrier on the carrier holder.

13. The processing system of Claim 8,
wherein the charge eliminator is configured to cover an entire surface of the electrostatic carrier from above the carrier holder, and comes into contact with the multiple chips on the electrostatic carrier at the same time, thereby taking earth for the multiple chips simultaneously.

14. The processing system of Claim 8, further comprising:
a protective film removing apparatus configured to remove a protective film formed on a device surface of the chip attracted to and held by the electrostatic carrier; and
a bonding apparatus configured to bond the chip attracted to and held by the electrostatic carrier onto a substrate on which the chip is to be mounted,
wherein the bonding apparatus comprises:
a second carrier holder configured to hold the electrostatic carrier;
a substrate holder configured to hold the substrate; and
an air supply configured to supply air toward the through hole formed in the main body of the electrostatic carrier on the second carrier holder.

15. The processing system of Claim 14,
wherein the bonding apparatus further comprises:
a first collet configured to hold and transfer the chip on the electrostatic carrier; and
a second collet configured to deliver the chip to/from the first collet and transfer the chip onto the substrate,
wherein the first collet is a non-contact chuck configured to hold the device surface of the chip in a non-contact manner.

16. The processing system of Claim 8, further comprising:
a protective film removing apparatus configured to remove a protective film formed on a device surface of the chip attracted to and held by the electrostatic carrier; and
a bonding apparatus configured to bond the chip attracted to and held by the electrostatic carrier onto a substrate on which the chip is to be mounted,
wherein the bonding apparatus comprises:
a second carrier holder configured to hold the electrostatic carrier;
a substrate holder configured to hold the substrate; and
a lift pin to be inserted into the through hole formed in the main body of the electrostatic carrier on the second carrier holder.

17. A processing method of processing multiple chips, comprising:
arranging and placing the multiple chips on a holding surface of an electrostatic carrier, which includes a main body having conductivity and provided with multiple through holes in a thickness direction thereof, and an insulating layer formed on a front surface of the main body;
supplying power to the main body to electrically charge the main body; and
bringing an earth wire into contact with the chip to generate an electrostatic force between the chip and the main body.

18. The processing method of Claim 17,
wherein the supplying of the power to the main body is performed prior to the placing of the multiple chips on the electrostatic carrier, and
the bringing of the earth wire into contact with the chip is performed after the placing of the multiple chips on the electrostatic carrier.

19. The processing method of Claim 17,
wherein the supplying of the power to the main body and the bringing of the earth wire into contact with the chip are performed after the placing of the multiple chips on the electrostatic carrier.

20. The processing method of Claim 17,
wherein the bringing of the earth wire into contact with the chip is performed simultaneously for the multiple chips placed on the electrostatic carrier.
